Europäisches Patentamt

European Patent Office

Office européen des brevets

(19)

(11) Publication number : 0 538 072 A2

# (12) EUROPEAN PATENT APPLICATION

(21) Application number : 92309508.7

(22) Date of filing : 16.10.92

(51) Int. Cl.⁵ : **G01R 33/12**

(30) Priority : **17.10.91 JP 296618/91**
**22.10.91 JP 301187/91**

(43) Date of publication of application :
**21.04.93 Bulletin 93/16**

(84) Designated Contracting States :
**CH DE FR GB LI**

(71) Applicant : **CANON KABUSHIKI KAISHA**
**30-2, 3-chome, Shimomaruko, Ohta-ku**
**Tokyo (JP)**

(72) Inventor : **Motoi, Taiko, c/o CANON**
**KABUSHIKI KAISHA**
**30-2, 3-chome, Shimomaruko**
**Ohta-ku, Tokyo (JP)**

Inventor : **Kishi, Fumio, c/o CANON**
**KABUSHIKI KAISHA**
**30-2, 3-chome, Shimomaruko**
**Ohta-ku, Tokyo (JP)**
Inventor : **Kaneko, Norio, c/o CANON**
**KABUSHIKI KAISHA**
**30-2, 3-chome, Shimomaruko**
**Ohta-ku, Tokyo (JP)**
Inventor : **Den, Tohru, c/o CANON KABUSHIKI**
**KAISHA**
**30-2, 3-chome, Shimomaruko**
**Ohta-ku, Tokyo (JP)**
Inventor : **Kobayashi, Tamaki, c/o CANON**
**KABUSHIKI KAISHA**
**30-2, 3-chome, Shimomaruko**
**Ohta-ku, Tokyo (JP)**

(74) Representative : **Beresford, Keith Denis Lewis**
**et al**
**BERESFORD & Co. 2-5 Warwick Court High**
**Holborn**
**London WC1R 5DJ (GB)**

(54) **Method and apparatus for detecting superconductor quench and method and apparatus for preventing superconductor quench.**

(57)   A method for detecting superconductor quench comprises a step (a) of entering light into an optical waveguide material arranged closely to a superconductor, and a step (b) of detecting a change of the incident light in the optical waveguide material.

## FIG.2

EP 0 538 072 A2

## BACKGROUND OF THE INVENTION

### Field of the Invention

The present invention relates to a method and an apparatus for detecting quench of a superconductive wire used for a superconductive coil, superconductive magnet, or superconductive cable, that is, detecting a trouble of the superconductive wire such as change from superconductive state to normally conductive state due to a cause under mechanical disturbance or disconnection caused by a generated electromagnetic force, and relates to a method and an apparatus for preventing quench by detecting the trouble of the superconductive wire.

### Related Background Art

Quench of a superconductive coil or superconductive magnet has been detected by measuring the terminal voltage of the coil or magnet. That is, this method uses the fact that the terminal voltage of the magnet or coil increases because an electric resistance is generated at a change portion when a superconductive wire is changed from superconductive state to normally conductive state.

When a magnet is electrified, an electromagnetic stress occurs and thereby, a superconductive wire is mechanically displaced. Therefore, the displacement has been detected by a piezoelectric element.

However, though the method for measuring a terminal voltage is simple, it has a problem that a quench portion cannot be detected until it gets large to a certain extent in order to detect the terminal voltage. That is, the terminal voltage to be detected generally requires approx. 0.1 V or higher when liquid helium is used as a refrigerant to avoid various types of noises though the terminal voltage to be detected depends on the magnet specification.

When a superconductive coil or superconductive magnet is constituted with oxide superconductors which are recently discovered, the temperature used comes to the liquid nitrogen temperature. In this case, because the superconductor is ceramic, it is estimated that a long superconductive wire necessarily have local defects. Therefore, safety design considering quench is required for a superconductive coil or superconductive magnet. However, even if the superconductive wire is stabilized with Cu, Al, or Ag, the terminal voltage to be detected comes to approx. $10^{-2}$ V in order to prevent the magnet from damaging due to quench when considering the electric resistance, specific heat, and heat capacity of Cu or the like at the liquid nitrogen temperature {Y. Iwasa et al., Cryogenics, Dec., Vol. 31, p. 711 (1980)}. When NbTi is used, it is shown that the heat of 900°C or higher is produced due to quench when the superconductive wire is disconnected even if 30% of stabilizing copper is used (Bong-Hwan Oh, et. al., T.IEE Japan, Vol. 112-B, p. 252). Moreover, the detection time of approx. 0.2 sec is required for NbTi when considering the current characteristic after quench because the terminal voltage of 0.1 V is generated. To use an oxide superconductor, it is necessary to detect quench in a shorter time. The terminal voltage of $10^{-2}$ V is 1/10 or less of the terminal voltage when liquid helium is used. Therefore, it is considerably difficult to accurately measure the terminal voltage in a short time under various types of electrical noises. Thus, it is estimated that the method for measuring the terminal voltage cannot actually be applied to a coil comprising an oxide superconductor using liquid nitrogen.

The detection method using a piezoelectric element is effective to detect the entire vibration of a coil or magnet. When an oxide superconductor is used, however, it is impossible to prevent the magnet from damaging unless quench in a micro area is detected more quickly than the case of an existing superconductive material such as $Nb_3Ti$ because, for example, $YBa_2Cu_3O_{7-x}$ has a large heat capacity of 1,000 $J/m^3K$ (77 K) and $Nb_3Ti$ has that of 0.5 $J/m^3K$ (4.2 K). However, it is difficult to accurately detect the mechanical-displacement in the micro area unless piezoelectric elements are arranged throughout a superconductive wire. It is not realistic to arrange piezoelectric elements for the overall length of the superconductive wire in view of processing of signals and manufacturing process of a coil or the like. Moreover, the piezoelectric element has a problem that the piezoelectric characteristic depends on temperature. To manufacture superconductive coils, superconductive magnets, or superconductive cables with a high reliability, it is indispensable to prevent a magnet from damaging by detecting quench under operation at an earlier stage as well as the advancement of the technique for manufacturing them.

It is said that quench is mostly caused by movement of a superconductive wire due to electromagnetic stress when direct current is applied to the wire though other causes are also considered. When alternating current is applied to the wire, the cause of quench is hardly clarified because a 50-Hz commercial superconductive wire was developed in 1980s. Therefore, it is also very important to clarify the mechanism of quench.

However, as described above, the existing method has a problem in its reliability, especially a problem that it cannot be applied to a temperature region higher than the liquid helium temperature (4.2 K) represented by the liquid nitrogen temperature (77 K) though it is simple.

Moreover, though the cause of quench is a controversial problem, there is another problem that the existing detection method is insufficient to clarify the mechanism of quench because the existing superconductive-wire trouble detection method only detects a trouble of a magnet or the like as a whole.

## SUMMARY OF THE INVENTION

It is an object of the present invention to provide a method and apparatus for detecting quench of a superconductive wire, capable of very accurately detecting a trouble at any temperature region, detecting a quench place, the temperature of the place, and change of quench with time in a short time, and contributing to clarification of the quench mechanism.

It is another object of the present invention to provide a method and apparatus for preventing quench, capable of taking necessary measures for preventing quench by detecting quench and decreasing the current to be applied in accordance with the detection signal or increasing the amount of refrigerant if a system for forcibly circulating the refrigerant is used.

It is still another object of the present invention to provide a superconductive wire having a function for detecting a trouble of the superconductive wire from the initial stage at any operating temperature. It is still another object of the present invention to provide a superconductive wire not only having a function for detecting a trouble of the superconductive wire but capable of specifying a place where the trouble occurs and obtaining various data values necessary for clarification of the trouble mechanism.

A first aspect of the present invention is directed to a method for detecting superconductor quench which comprises (a) a step of entering light into an optical waveguide material arranged closely to a superconductor, and (b) a step of detecting a change of the incident light in the optical waveguide material.

A second aspect of the present invention is directed to an apparatus for detecting superconductor quench which comprises an optical waveguide material arranged closely to a superconductor, a means for entering light into the optical waveguide material, and a means for detecting a change of the incident light in the optical waveguide material.

A third aspect of the present invention is directed to a superconductive wire in which a superconductor is constituted integrally with an optical waveguide material via a substrate.

## BRIEF DESCRIPTION OF THE DRAWINGS

Fig. 1 is an illustration showing the progression of light in an optical waveguide section when no quench occurs;
FIG. 2 is an illustration showing the progression of light in an optical waveguide section when quench occurs;
Fig. 3 is an illustration showing the principle of the cross-sectional structure of a superconductive wire;
Fig. 4 is a schematic of the quench detecting apparatus of the present invention;
Fig. 5 is a timing chart when no quench occurs;
Fig. 6 is a timing chart when quench occurs at one place;
Fig. 7 is a timing chart when quench occurs at two places;
Fig. 8 is a schematic of the quench preventing apparatus of the present invention;
Fig. 9 is a schematic showing another mode of the quench detecting apparatus and quench preventing apparatus of the present invention;
Fig. 10 is an enlarged view of the superconductive-coil section in Fig. 9;
Fig. 11 is an illustration showing the principle of the cross-sectional structure of the superconductive wire of the present invention;
Fig. 12 is a schematic showing still another mode of the quench detecting apparatus of the present invention;
Figs. 13A and 13B are illustrations for electric signals obtained from an embodiment of the present invention;
Figs. 14A and 14B are illustrations showing the principle of the manufacturing process of a superconductive wire;
Figs. 15A and 15B are illustrations showing the manufacturing process of the optical waveguide section of the superconductive wire of the present invention;
Figs. 16A and 16B and Figs. 17A and 17B are illustrations showing the principle of the manufacturing process of the superconductive wire of the present invention;
Fig. 18 is an external view of the superconductive wire of the present invention; and
Figs. 19, 20 and 21 are illustrations showing the principle of the cross-sectional structure of another mode of the superconductive wire of the present invention.

## DETAILED DESCRIPTION OF THE PREFERRED EMBODIMENTS

The present invention makes it possible to very accurately-detect quench at any temperature by detecting the state of reflection, transmission, scattering, or polarization of the light entering an optical waveguide material arranged closely to a superconductor.

Moreover, the present invention makes it possible to detect a quench place, the temperature of the place, and the change of quench with time in a short time in accordance with the detected data

Further more, the present invention makes it possible to prevent quench in accordance with the detected data.

The present invention is described below in detail by using preferred embodiments.

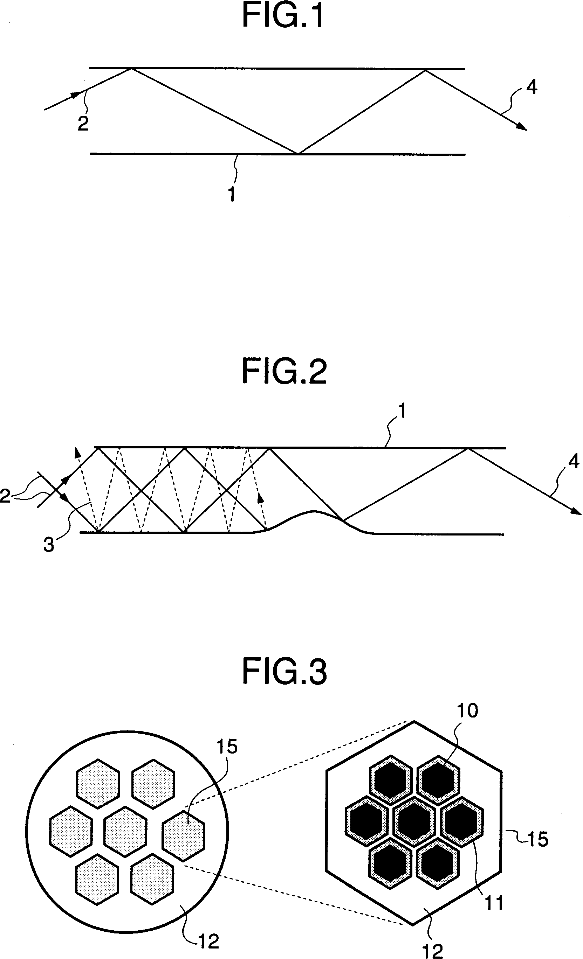

Figs. 1 and 2 are conceptual views showing the principle of the present invention. In Fig. 1, symbol 1 is an optical waveguide and 2 is the light incoming from one end of the optical waveguide, which progresses in the direction of symbol 4.

The principle of the present invention is described below by taking a superconductive magnet as an example. A superconductive wire 15 used for the superconductive magnet generally has the cross-sectional structure shown in Fig. 3. That is, a superconductor 10 with the diameter of $10^{-1}$ to $10^{1}\mu m$ is covered with a low-resistance material 11 (which is called a stabilizing material and normally uses Cu or Al) and the low-resistance material 11 is further covered with a matrix material 12. Thus, a superconductor as shown in Fig. 3 is formed by the superconductive wire 15 having the above structure. The superconductive magnet is formed by winding the superconductor into a desired shape.

When current is applied to the superconductor, a magnetic field is generated around one of the superconductive thin wires 15 and thereby, each superconductive thin wire 15 is provided with an electromagnetic stress. The stress is a circumferential tensile stress with the magnitude of "(winding diameter) x (magnetic field) x (space current density)", which frequently comes to approx. $10^{2}$ MPa though it depends on the specification of the magnet.

Therefore, when the magnet is electrified, each superconductive wire 15 is distorted due to the stress. Thus, the superconductive thin wire 15 causes a displacement larger than its diameter depending on the amount of current and moves.

In this case, when an optical waveguide is set around the superconductive wire 15, the optical waveguide is deformed due to the movement of the superconductive wire from the state in Fig. 1 to the state in Fig. 2. If quench occurs due to various causes including crystal distortion or cracks of the superconductor or its peripheral stabilizing material caused by the electromagnetic stress or local defects of the superconductor's own, an electric resistance is generated at the quench portion and heat is produced because the portion changes from the superconductive state to the normally conductive state. Thus, the optical waveguide is further deformed due the produced heat.

Unless deformation occurs, the light in the optical waveguide progresses from one end to the other of the waveguide at the transmittance according to the waveguide specification as shown in Fig. 1. However, if deformation occurs, the light 2 incoming from one end of the waveguide is divided at the deformed portion into the emitted light 4 progressing up to the other end of the waveguide and the reflected light 3 returning to the original position. In this case, it is possible to determine a place where deformation occurs, by measuring the time until the reflected light 3 returns to the original position after the light enters the waveguide.

That is, quench of the superconductive magnet can be decided by presence or absence of the reflected light 3. Moreover, because the intensity of the reflected light 3 increases and that of the emitted light 4 reaching the other end of the waveguide decreases when deformation is large, the deformation degree can be estimated by the difference between the intensity of the emitted light 4 and that of the incident light 2.

Moreover, because the incident angle of light to the waveguide wall is different from the total reflection condition at the deformed portion, Raman scattering occurs at the portion and Raman light with a wavelength different from that of the incident light 2 is included in the reflected light 3 or the emitted light 4 when occasion demands. Therefore, Stokes Raman line and anti-Stokes Raman line can be detected by dispersing the light with a spectrometer. Thus, the temperature change value at the deformed portion can be calculated by measuring the intensity ratio between these Raman lines.

The wavelength of the light entering the optical waveguide used for the method of the present invention is unlimited. For example, the light may be a semiconductor laser beam with the wavelength of about 1 μm, argon ion laser beam with the wavelength of around 500 nm, and various types of light-emitting-diode beams. Though pulsating light is preferable, continuous light is no problem by pulsing the light with a chopper or the like. It is only necessary to properly select the intensity of a light source by considering the sensitivity of a photodetector. Because there is no restriction on light detection, it is possible to use a photomultiplier, streak camera, CCD camera, or boxcar integrator for detection of a feeble light.

It is possible to use a spectrometer with the resolution of 10 cm$^{-1}$ or less for detection of Raman light.

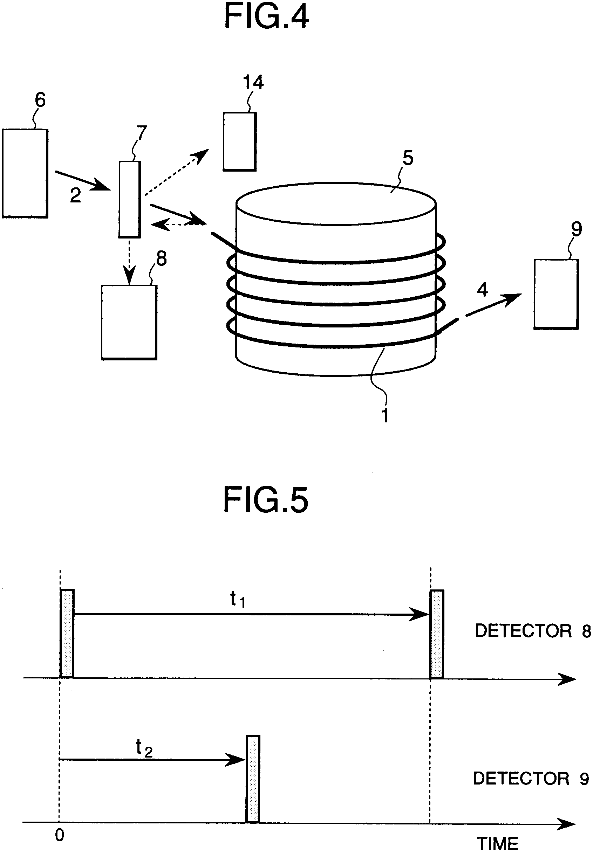

Fig. 4 is an illustration showing the principle of the measuring method of the present invention and Figs. 5 to 7 show timing charts for measurement. In Fig. 4, symbol 5 is a superconductive magnet in which an optical waveguide 1 is set around a superconductive wire having the structure shown in Fig. 3. Portions other than the both ends of the optical waveguide 1 are kept at a temperature lower than the critical temperature of a superconductor by a cooling system not illustrated. A light source 6 for detecting quench is a pulse laser beam generated every time of $t_1$ and photodetectors 8 and 9 detect light with a photomultiplier provided with a gate or the like and process signals with a computer not illustrated. Pulse light is divided into two parts of light by a beam splitter 7. One enters the optical waveguide 1 and the other enters the photodetector 8. When assuming the moment when the photodetector 8 detects light as the time 0 and the length of the optical waveguide as "L", the light reaches the photodetector 9 after $t_2$ sec. The time $t_2$ is obtained by the following expression:

$$t_2 \text{ (sec)} = L \text{ (m)}/3 \times 10^8 \text{ (m/sec)}$$

Where, "$3 \times 10^8$ (m/sec)" is the speed of light.

If no quench occurs in the magnet 5, the photodetector 9 detects the light after $t_2$ sec as shown in Fig. 5, while the photodetector 8 detects nothing during the period.

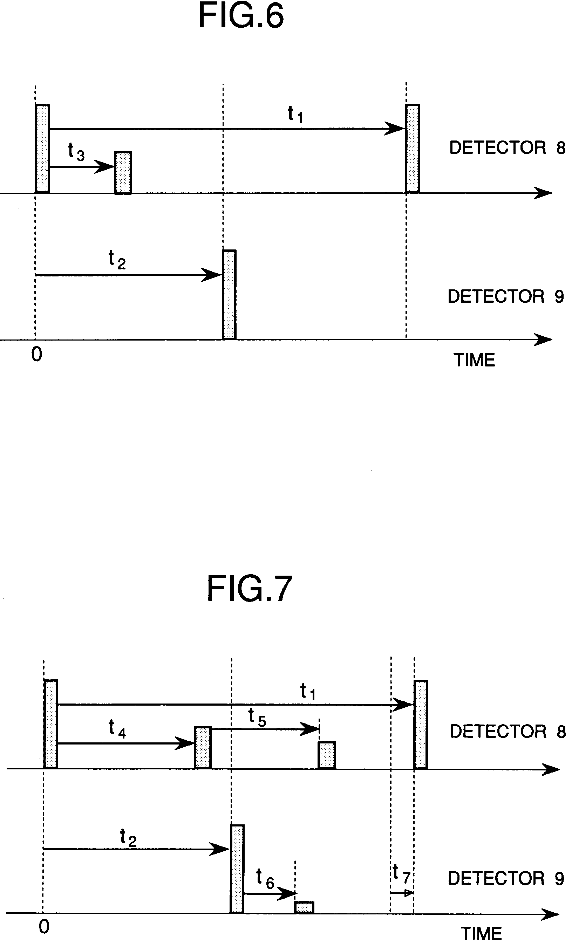

However, if quench occurs at one place in the superconductive wire, the waveguide is deformed as shown in Fig. 6 and thereby, the reflected light 3 from the deformed portion is detected after $t_3$ sec within "$2 \times t_2$" sec. Therefore, it is necessary for the photodetector 8 to perform measurement starting with the time 0 by assuming "$2 \times t_2$" sec as one cycle and for the photodetector 9 to perform measurement every $t_2$ or "$2 \times t_2$" sec as shown in Fig. 5.

Fig. 7 shows a case in which quench simultaneously occurs at, for example, two places in the superconductive wire. That is, the reflected light from the deformed portion at a place close to the light entrance of the optical waveguide is detected by the photodetector 8 after $t_4$ sec and that at a place far from the entrance is detected by the photodetector 8 after ($t_4 + t_5$) sec. When the photodetectors 8 and 9 operate at the same gate interval, the emitted light is detected by the photodetector 9 after $t_2$ sec and the light returned from the deformed portion is detected by it after $t_6$ sec.

When setting the pulsating laser beam generating characteristic value "$t_1$" so that it is larger than "$2 \times t_2$", a measuring idle time of $t_7$ sec is produced. However, it is found that the places where quench occurs are present at positions "$(t_4/2) \times (3 \times 10^8)$" m and "$\{(t_4 + t_5)/2\} \times (3 \times 10^8)$" m apart from the beam splitter 7.

Moreover, the deformation degree can qualitatively be determined by the light intensity at the photodetector 8 at the time 0 and the light intensity at the photodetector 9 at the time $t_2$ or the light intensities at the photodetector 9 when no quench occurs (e.g. before electrification) and at the time $t_2$ when quench occurs.

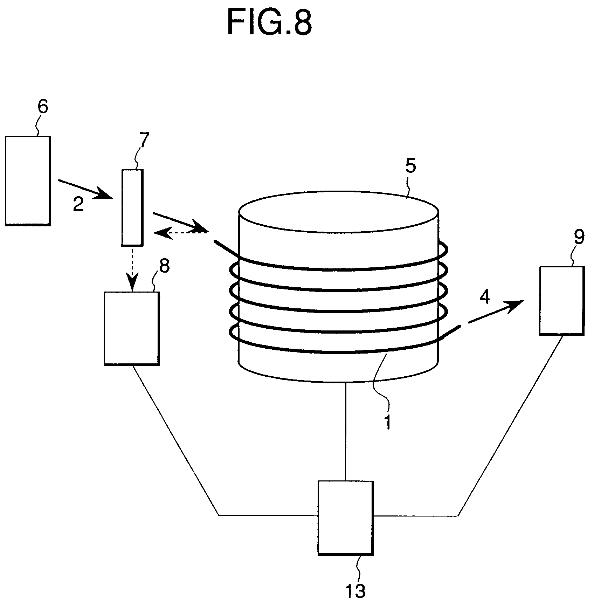

The quench preventing apparatus of the present invention uses the principle of the above quench detection. In Fig. 8, symbol 5 is a superconductive coil for which quench should be prevented, 1 is an optical waveguide section, 6 is a light source, 7 is an optical system for applying the light 2 emitted from the light source to the optical waveguide section and leading the reflected light to the photodetector 8, 9 is a photodetector for detecting the emitted light 4, and 13 is a controller for processing signals from the photodetectors 8 and 9 and controlling the amount of current to electrify the superconductive coil.

When electrification of the superconductive coil starts, an electromagnetic stress is generated due to the electrification and quench occurs in the superconductor and its peripheral stabilizing material due to various causes including crystal distortion during manufacturing, local structural defect, and microcracks. When the quench occurs, the optical waveguide section is locally deformed as shown in Fig. 2 and thereby, reflected light at the deformed portion is detected by the photodetector 8 and emitted light with a decreased intensity is detected by the photodetector 9. When assuming the time the light 2 enters the optical waveguide section as the time 0, the time the light is detected by the photodetector 8 depends on a place where quench occurs. For the photodetector 9, however, the time is determined by the length of the optical waveguide section. Therefore, the timings when the emitted light and the reflected light are detected by the photodetectors 8 and 9 are different from each other. In any case, however, detection of the light by the photodetector 8 and decrease of the intensity of the light detected by the photodetector 9 represent that quench occurs. Therefore, when a change is detected by the photodetector 8 or 9, it is necessary to decrease the amount of electrification current by sending photoelectric-transduced signals from the photodetector to the controller 13. Thereby, it is possible to prevent more heat from being produced in the quench portion and.prevent disconnection of a superconductive wire. When the superconductive wire is long and the controller has a slow response speed, the photodetectors 8 and 9 are operated to control the amount of current by either photodetector which detects a trouble earlier. When the superconductive wire is short and the difference of detection time between the photodetectors 8 and 9 is microsecond order or lower, it is possible to omit either photodetector. For a superconductive wire having a structure in which a thin tube for flowing refrigerant is provided closely to the superconductive thin wire 10 in Fig. 3 in order to improve the cooling efficiency, it is possible to prevent quench by controlling the refrigerant flow rate with signals from the photodetectors 8 and 9.

When a trouble of the superconductive wire is detected, it is possible to set the amount of electrification current and refrigerant flow rate with the controller arbitrarily according to the purpose.

The following is the description of another mode of the present invention.

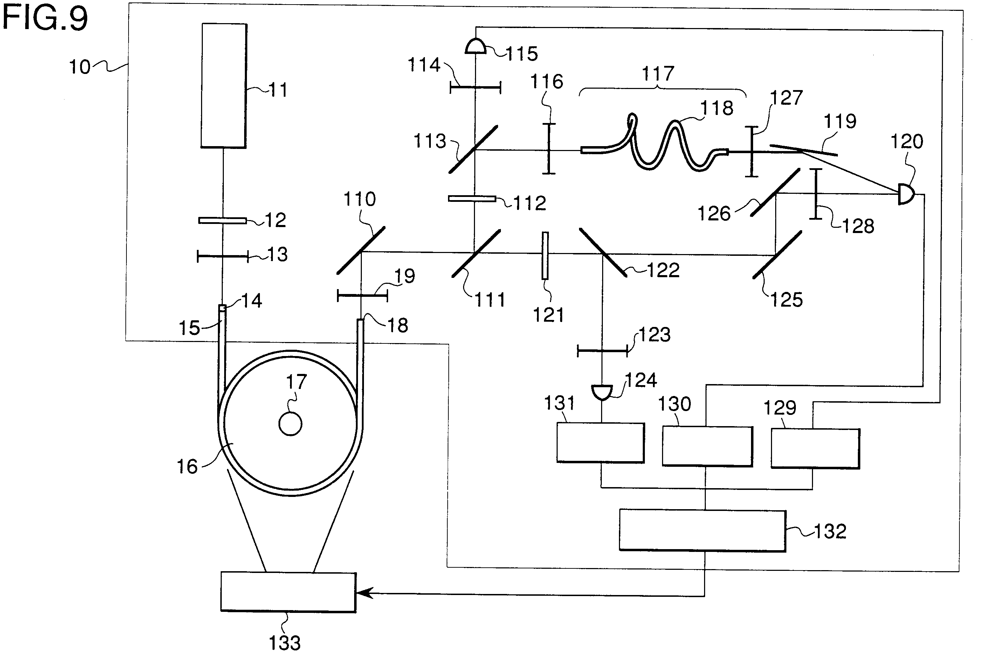

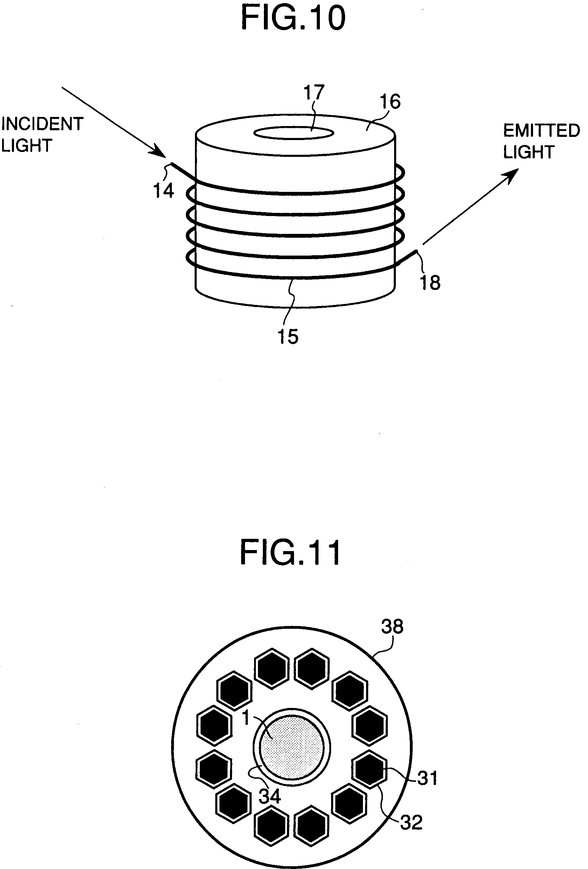

Fig. 9 is a schematic of a main section related to another mode of the quench preventing apparatus of the present invention. Fig. 10 is a perspective view of the coil 16 in Fig. 9. Symbol 16 is a coil made of a superconductive wire, which is designed so as to generate a strong magnetic field at a central portion 17. This strong-magnetic-field generator is a general apparatus, which is applied to various fields such as a nuclear fusion system, elementary-particle acceleration system, radiation medical system using an acceleration system, and magnetic resonance detection system.

An optical fiber 15 is wound on a strong-magnetic-field generator with a superconductive wire according to the present invention as shown in Fig. 10. One end 14 of the optical fiber is an entrance of optical signals, which is connected with a laser beam source 11 through a polarizing plate 12. The other end 18 of the optical fiber 15 is an optical-signal output portion which is divided into two beams before each of them is introduced into light-intensity detectors 115, 124, and 120 through polarizing plates 112 and 121 perpendicular to each other.

In this mode, it is possible to detect quench of a superconductor by detecting how the state of the polarized coherent light incoming from the incident portion changes at the output unit after passing through the optical waveguide and how the phase of the polarized component changes. Moreover, as described above, it is possible to prevent quench from increasing by returning the detected data to a control system for controlling the amount of current to be supplied to the superconductive coil or the flow rate of refrigerant.

In the above modes, the optical waveguide material is wound on the superconductive coil. However, the following superconductive wire is preferably used for detection and prevention of quench.

Fig. 11 is an illustration showing the principle of the cross-sectional structure of the superconductive wire of the present invention. As shown in Fig. 11, the superconductive wire of the present invention comprises a superconductor 31, a stabilizing material 32 which is comprised by a low resistance material covering the superconductor 31, an optical waveguide material 1, a heat transferring material (or heat insulating material) 34 covering the optical waveguide material 1, and a supporting material 38 for supporting the above components. That is, for the superconductive wire of the present invention, the optical waveguide material is locally deformed when the superconductive wire moves according to the above principle because the optical waveguide material is present very closely to the superconductive wire. When the superconductive wire is not displaced at all, no local deformation occurs in the optical waveguide material 1. Therefore, when the light 2 enters the optical waveguide material 1, the light 2 entirely reaches the other end of the optical waveguide material as shown in Fig. 1. However, if the optical waveguide material 1 is deformed, the reflected light 3 returns to the light entrance from the deformed portion as shown in Fig. 2.

Therefore, for the superconductive wire of the present invention, it is possible to detect various troubles of the superconductive wire and trouble occurrence places by measuring presence or absence of the reflected light 3 or the time until the reflected light 3 returns to the light entrance.

The superconductive wire of the present invention can be made with a method almost the same as that for the existing superconductive wire. There is no restriction on the superconductor, stabilizing material, and supporting material used for the superconductive wire of the present invention though it is necessary to select them according to the purpose. Therefore, it is possible to make the superconductive wire of the present invention through the diffusion method (e.g. surface diffusion method, bronze method, in-situ method, and powder method), quenching method (e.g. melt extraction method and high energy beam irradiation method), or vapor deposition method. To make the superconductive wire, it is necessary to select the best method among these methods according to the material used.

Also, any materials can be used as the optical waveguide material 1 for the superconductive wire of the present invention unless the light transmittance of the optical waveguide material 1 is zero. It is possible to disuse the heat transferring material or heat insulating material 34 for covering the optical waveguide material 1 if it is unnecessary.

The present invention is described below more minutely according to examples.

Example 1:

Fig. 4 shows the measuring method of the present invention. The optical fiber 1 is wound helically on the superconductive magnet 5. The fiber length is 300 m. The light source 6 uses an argon ion laser with the output of 10 mW (wavelength: 488 nm).

Symbol 7 is an optical system comprising primarily a chopper to be operated at 50 Hz and two beam splitters. The incoming light is divided into the light progressing toward the fiber 1 and the lights progressing toward the detectors 8 and 14. The optical system 7 converts the light from the argon ion laser into the pulsating light with the interval of 20 msec and its pulse width can optionally be set depending on the slit width of the chopper. For this example, the pulse width is set to 1 msec.

The detectors 8 and 9 are controlled by a computer (not illustrated) so that the gate opens for 10 psec at the interval of 10 psec during the period of 2,000 psec after the light from the argon ion laser 6 reaches the detector 14 and then closes until the next pulse reaches the detector 14.

Measurement was performed by cooling the superconductive magnet 5 and operating the argon ion laser 6 before electrification. In this case, no optical signal was detected by the detector 8 but an optical signal was detected by the detector 9 after 1,000 psec.

As the result of applying current to the superconductive magnet 5, light was detected by the detector 8 twenty psec after the gate opens, that is, when the gate opened at the second time. After that, light was detected whenever the gate opened up to 2,000 psec. Light was also detected by the detector 9 after 1,000 psec up to 2,000 psec when the gate closes.

As a result, it is found that quench occured at the position 3 to 4.5 m apart from the beam splitter.

Example 2:

According to the same method as that for Example 1, a YAG laser with the pulse width of 20 psec was used for the light source 6. Optical signals were measured by opening the gates of the detectors 8 and 9 for 10 psec at the interval of 10 psec during the period of 2,000 psec.

As a result, a signal was detected by the detector 8 after 560 psec, that is, when the gate opened at the 28th time but no signal was detected when the gate opened at the 29th time. Also, a signal was detected by the detector 9 after 1,000 psec, that is, only when the gate opened at the 50th time.

Therefore, it is found that quench occurred at a position between 84 and 87 m apart from the beam splitter and it occured only at this position.

Example 3:

According to the same method as that for Example 2 except that the photodetector 14 was not used, a laser with the pulse width of 10 psec was used for the light source 6 to determine the the time criterion for measurement by using time signals for generating a pulsating laser beam.

The gates of the detectors 8 and 9 were opened only for 10 psec at the interval of 10 psec during the period of 2,000 psec. As the result of applying the current of 150 A to the superconductive magnet 5, light was detected by the detector 8 when the gate opens at the 10th time, 11th time, and 48th time respectively.

From the above fact, it is found that quench occurred at two places in the ranges from 30 to 36 m and from 144 to 147 m. Though light was detected by the detector 9 at the 50th time and 124th to 126th times during measurement, the signal intensity at the 124th to 126th times was 1/100 or less of the signal intensity at the 50th time.

The light detected when the gate opened at the 50th time is the emitted light from the light source 6 and the light detected when the gate opened at the 124th to 126th times is the light returned from the two deformed portions. Therefore, it is found that the quench at a position close to the entrance started with a place 31 m apart from the beam splitter. Moreover, when the gate opened at the 32nd time after 30 sec, a new signal was detected by the detector 8. That is, it is found from the value of 30 sec after electrification that quench newly occurred at a position 96 to 99 m apart from the beam splitter.

Example 4:

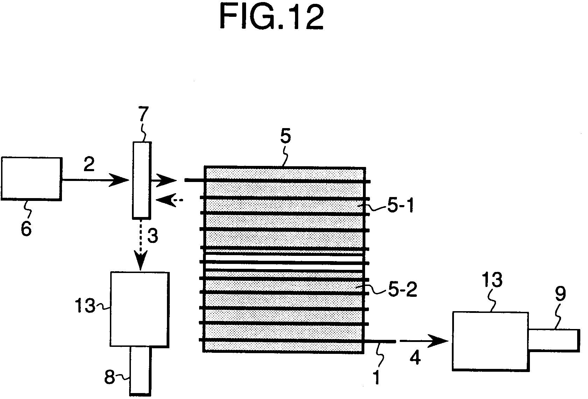

Fig. 12 shows another mode of the detection method of the present invention. In Fig. 12, symbol 13 is a spectrometer including the collimator of the focal length of 30 cm and the detector 8 is a 1024-channel photodetector with a gate.

The light emitted from the light source 6 (YAG laser) consists of a second harmonic wave generated by a non-linear optical single crystal, which has the pulse width of 20 psec and is generated at the interval of 1 sec. The superconductive magnet 5 is divided into two sections. Symbol 5-1 is a first magnet close to the light source and 5-2 is a second magnet close to the detector 9. The optical fiber 1 wound on the superconductive wire of them has the length of 150 m for the section 5-1 and the length of 200 m for the section 5-2. The length of the optical fiber between the first and second magnets is 50 cm. The temperature of the magnet 5 is kept at 77 K by liquid nitrogen.

The gates of the detectors 8 and 9 are controlled by a computer (not illustrated) so that they open for 20 psec and then close for 10 psec. When the detectors are not electrified, no reflected light is detected by the detector 8 but only emitted light is detected by the detector 9.

However, when the measuring range of the spectrometer 5 was set so that the second harmonic wave could be detected at the middle channel of 1,024 channels or the channel 512 and the each magnet 5 was electrified, an optical signal was detected by the detector 8 when the gate opened at the 20th time but the scales of channels 511 to 513 were exceeded due to excessive light intensity. However, a signal was also detected at the channels 12 and 1012. The light detected at the channels 12 and 1012 serves as Raman scattering light of the quartz glass constituting the optical fiber section of the optical fiber 1 and the optical signal detected at the channel 12 is Stokes Raman line and that detected at the channel 1012 is anti-Stokes Raman line.

As the result of calculating the quartz-glass temperature in accordance with the Raman-line intensity by assuming Boltzmann distribution, it is obtained as approx. 79 K. Therefore, it is found that the optical fiber was deformed at the portion of 90-93 m or at the portion of the magnet 5-1, the temperature of the portion was approx. 79 K, and the temperature rose by 2 K.

The strong optical signal detected at the channels 511 to 513 is the reflected light produced by the fact that the light from the light source 6 reflected at the deformed portion.

Moreover, it is found that a signal was only detected by the detector 9 after approx. 1,500 psec and no trouble occurred in the magnet 5-2. In Fig. 8, the spectroscope 13 is also mounted on the detector 9. However, it is not necessary to mount the spectroscope when Raman scattering light is not measured.

As described above, the quench detecting method of the present invention makes it possible to detect not only a trouble but the characteristic of the portion where the trouble occurs, the temperature of the portion where the trouble occurs, and temporal process of trouble occurrence in a very short time regardless of the superconductive wire temperature in, for example, detecting a trouble of the superconductive wire used for a superconductive magnet or the like.

Moreover, the present invention makes it possible to obtain various data values for minutely clarifying the cause and process of quench.

Example 5:

Fig. 8 shows a block diagram of the apparatus of the present invention. The optical waveguide section 1 is mounted outside the superconductive wire of the superconductive magnet 5, that is, the supporting material 12 in Fig. 3. The light source 6 uses an argon ion laser with the output of 10 mW (wavelength: 488 nm). The present invention uses the output of 3 mW. The light receiving sections of the detectors 8 and 9 use a photodiode respectively. The output of the photodiode is converted into electric signals by an optical coupler made by combining a light emitting diode and a photodiode and connected to the controller 13. The controller 13 normally controls the amount of current for electrification of the superconductive magnet independently. However, when the controller receives a signal from the detector 8 or 9, it controls the signal with a computer so that the signal is processed in the highest priority. The detector 8 or 9 may be housed in an electromagnetically shielding container.

The superconductive magnet was cooled by a cooling system (not illustrated) and electrification of the magnet was started by the controller 13. Before starting the electrification, the argon ion laser was operated to measure the intensity of emitted light with the detector 9. When slowly increasing the amount of current after the electrification, the detector 8 detected light at approx. 40% of the critical current of the superconductive magnet and almost simultaneously the detection sensitivity of the detector 9 lowered. Therefore, the controller 13 operated to decrease the amount of electrification current to zero and then it was confirmed that the intensity of detected light was stabilized in the detector 9 to restart electrification. Then, as the result of continuing electrification up to 65% of the critical current, the detector 8 detected light again. Therefore, the amount of current was decreased to 5% of the amount up to then and electrification is restarted after the detected intensity at the detector 9 was stabilized. By repeating the above operation five times, it was possible to flow current up to 90% of the critical current of the superconductive magnet and operate the magnet under this condition.

Example 6:

With almost the same constitution as Example 5, the light source 6 uses a YAG laser with the pulse width of 20 psec and the detectors 8 and 9 use a CCD camera with time resolution respectively. For this example, the optical waveguide section has the length of 300 m. The detectors 8 and 9 synchronize with the light source and the gates of them open for 10 psec at the interval of 10 psec during the period of 2,000 psec after the laser beam generation to detect light.

After the superconductive magnet was electrified, a laser beam was emitted every second. The laser beam emitted before electrification was detected by the detector 9 after 1,000 psec. Then, similarly to Example 5, the amount of current for electrification was slowly increased. However, because the gate of the detector 8 opened at the 28th time after the laser beam was emitted and light was detected by the detector 8 when electrification was continued up to 35% of the critical current, the amount of current for electrification was decreased to 10% of the amount up to then by the controller 13. Light was detected by the detector 8 only when the gate opened at the 28th time but it was not detected when the gate opened at the 29th time forward. Also, light was detected by the detector 9 only when the gate opened at the 50th time or after 1,000 psec but the light intensity was 80% of the light intensity detected immediately before electrification. Therefore, because the speed of light is 3 x $10^8$ m/sec, it is found that quench occurred within the range of approx. 3 m when the gate of the detector 8 opened at the 28th time, that is, when the light progressed by the distance of "20 x 28 (psec) x 3 x $10^8$ (m/sec)/2 = 84 (m)". Because the controller 13 was programmed so that the amount of current for electrification was decreased when a first abnormal signal after emission of the laser beam was detected by the detector 8 or 9, the controller did not respond to the signal from the detector 9 after 1,000 psec though it was operated according to the instruction from the detector 8 after 560 psec. Then, the light intensity at the detector 9 was measured to confirm that the intensity fluctuation was kept at 3% or less before restarting electrification with the controller 13.

Figs. 5 and 6 show the timing charts of the laser and detector used for this example. Unless any trouble occurs in a superconductive wire, the timing chart is as shown in Fig. 5. That is, when the laser-beam emission frequency is set to once for $t_1$ sec (it is set to once per sec for this example), the detector 8 detects the light emitted from the light source every $t_1$ sec by synchronizing the light source with the detector and dividing the light from the light source by the beam splitter of the optical system 7. When assuming the length of the optical waveguide section as L, the detector 9 detects light after "$t_2$ (sec) = L x (speed of light)". However, because a change appears as shown in Fig. 2 if a trouble occurs, reflected light is detected by the detector 8 after $t_3$ sec within $2t_2$ sec and light weaker than that in Fig. 5 is detected by the detector 9 after $t_2$ sec. Therefore, it is possible to perform measurement by assuming the timing when a laser beam is emitted or the detector 8 detects light as the time 0 and $2t_2$ sec as one cycle. A trouble of.the superconductive wire is detected by detecting reflected light with the detector 8 or detecting decrease of the light intensity with the detector 9. In this case, it is necessary to control the controller 13 in the shorter time of $t_3$ and $t_2$. When a plurality of troubles occur, it is necessary to control the controller 13 at the timing of the first-detected trouble. The portion where a trouble occurs can be determined by performing calculation according to the timing when light is detected though a measurement idle time of "n x $2t_2$ - $t_1$" sec by setting the laser-beam emission characteristic value $t_1$ so that it is equal to or larger than "(n x $2t_2$)" (n: integer equal to or more than 1). It is possible to determine the value of "n" according to the specifications of the laser and detector used.

Example 7:

For Example 5, only reflected light is detected by the detector 8, and the detector 9 is omitted and a light absorbing material is used for the portion of the detector 9. Though the controller 13 was controlled by the detector 8 when a trouble occurred, quench could be prevented similarly to the case of Example 5.

Example 8:

For Example 6, the detector 8 and optical system 7 are omitted. Though the controller 13 was controlled by measuring the light intensity only with the detector 9, quench could be prevented similarly to the case of Example 1. When quench occurs at a plurality of positions, the measurement results by a detector become complex. However, to prevent quench, it is possible to control a controller for the first trouble. To determine a portion where quench occurs, the portion can accurately be determined by decreasing the width of the detector gate, in other words, by improving the time resolution.

As described above, the quench preventing apparatus of the present invention detects a trouble of a superconductive wire used for a superconductive magnet or the like as an optical signal without being restricted by the operating temperature of the superconductive wire or without being affected by electrical noises. Therefore, it is possible to control the amount of electrification current from the initial stage of quench and safely apply current to the superconductive wire. A position where quench occurs can be determined at the accuracy of 30 cm for the time resolution of 1 psec though the positional accuracy varies depending on the time response performance of a detector. Moreover, because not only a trouble can be detected but a portion where the trouble occurs can be specified, it is possible to evaluate the trouble occurrence characteristic at any position of the superconductive wire and estimate the operating limit of the wire.

Example 9:

The example of the quench detecting apparatus of the present invention is concretely described below by referring to Fig. 9. In Fig. 9, symbol 10 is the quench detecting apparatus of the present invention. Symbol 11 is a light source for emitting coherent light. This example uses a He-Ne laser for the light source. Symbol 12 is a polarizing plate which is set to realize a predetermined polarizing state. Symbol 13 is a lens for focusing light, which is designed so that light uniformly enters a waveguide (or waveguide bundle which is hereafter referred to as the waveguide). The light continuously emitted from the light source 11 is polarized by the polarizing plate 12 and enters the fiber 15 through the lens 13. The light entering the fiber 15 passes through a fiber wound on a strong-magnetic-field generator (symbol 15 in Fig. 10) and passes through one end 18 of the fiber, an objective lens 19, and mirror 110 before entering a half-mirror 111. The angle, refractive index, and thickness of the half-mirror used for this embodiment are properly designed so that the reflectance does not vary depending on polarized light. (Instead of the above design, it is possible to control the polarizing plates 12, 112, and 121 so that polarized light to be observed is most efficiently reflected or transmitted. It is also possible to use a polarizing beam splitter instead of the half-mirror.) Each 50% of the light thus entering the half-mirror 111 enters polarizing plates 112 and 121 according to the rate of light intensity regardless of the polarized state. In this case, directions of the polarizing plates 112 and 121 are determined so that they have effectively perpendicularly polarized state. The light entering the polarizing plate 112 is polarized and divided into two light beams by the half-mirror 113. One divided light enters a light-intensity sensing element 115 through an optical system 114. That is, the intensity of the light under the polarized state determined by the polarizing plate 112 is measured. Similarly, the other divided light passing through the half-mirror 111 passes through the polarizing plate 121 perpendicular to the polarizing plate 112 and then it is divided into two lights again by the half-mirror 122. One divided light enters a light-intensity sensing element 124 through an optical system 123, where the light intensity in the direction vertical to the polarization direction measured by the light-intensity sensing element 115 is measured.

The light divided by the half-mirror 113 passes through an optical system 116, a device 117 for rotating polarized light by 90°, and optical system 127 and enters a mirror 119 where the direction of the ray is changed before progressing to the surface of a light-intensity sensing element. In this case, this example uses a method using the distribution of the space curve of an optical fiber for changing the polarization direction. Therefore, as the polarization-direction changing device 117, an optical waveguide 118 is used which is designed so that the spatial position is fixed and polarization direction is changed by 90°. (However, it is possible to use other method as the polarization-direction changing device.) The light passing through the half-mirror 122 is changed in its direction by mirrors 125 and 126 and passes through an optical system 128 before progressing to the surface of a light-intensity sensing element 120. Because the light A reflected from the mirror 119 and the light B reflected from the mirror 125 enter the light-intensity sensing element 120 with an angle, they form interference patterns on the surface of the light-intensity sensing element 120. The phases of the lights A and B are fluctuated due to the displacement of the waveguide wound on the strong-magnetic-field generator 16. The fluctuation of the phases appears as the fluctuation of interference patterns formed on the surface of the light-intensity sensing element 120. For this example, the directions of the polarizing plates 12, 112, and 121, and the direction of the mirror 119 are properly adjusted in the initial state so that the-light-intensity sensing element efficiently detects the fluctuation. This adjustment can automatically be made as described below by the control section 132 of the quench detecting apparatus of the present invention as initialization before starting the apparatus.

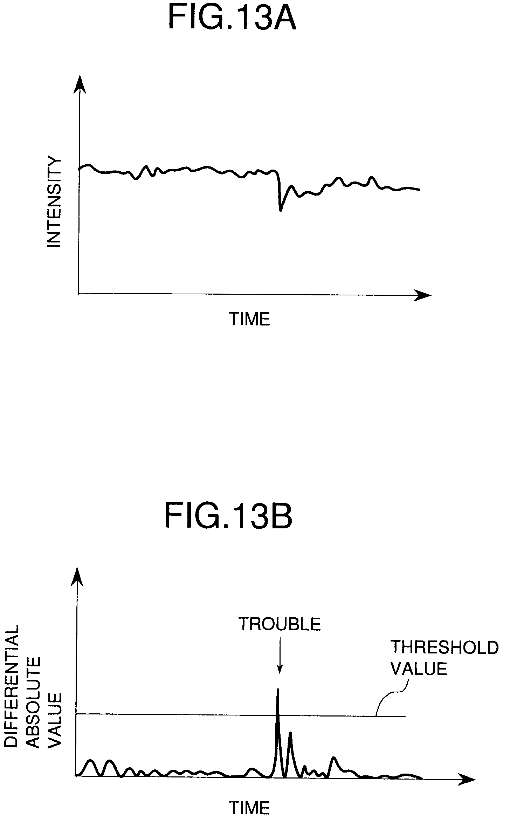

Thus, electric signals obtained by the light-intensity sensing elements 115, 124, and 120 are sent to the signal processors 129, 130, and 131 respectively, where they are processed. Signal processing is performed by arranging the electric signals together with time as a time series (Fig. 13A). For example, when the absolute value of a differential component in the time direction is equal to or more than a certain threshold value, it is judged that displacement or other trouble occurs in the waveguide wound on the strong-magnetic-field generator (Fig. 13B). Because this is equivalent to a trouble due to quench of the strong-magnetic-field generator as described above, quench can be detected through the above signal processing.

Therefore, when each signal processor detects a trouble, it notifies the control section 132 of the quench detecting apparatus that the trouble occurs. The control section 132 statistically processes thus obtained abnormal signal. When the control section 132 decides that the signal is abnormal, it notifies the control section of the strong-magnetic-field generator that a trouble occurs.

The control section of the strong-magnetic-field generator controls the current flowing through the generator so that, for example, the current quickly decreases in accordance with the signal indicating that a trouble occurs sent from the control section 132 of the quench detecting apparatus. Thus, the trouble or quench caused in the strong-magnetic-field generator is detected at the initial stage of the quench, Joule heat is prevented by, for example, decreasing the amount of current, and quench is prevented from spreading in the entire system.

For this example, the quench detecting apparatus of the present invention is described by taking the strong-magnetic-field generator using the superconductive wire as an example. However, it is the essence of the present invention to detect quench of a superconductive wire. Therefore, it is clear that the present invention can be applied to more-popular systems using a superconductive wire such as a large-power transmission system and large-power storage system and it is noticed that the present invention can easily be applied.

Example 10:

For the superconductive wire of the present invention, as shown in Fig. 11, a plurality of superconductive thin wires 31 each of which is covered with the stabilizing material 32 are arranged in the supporting material 38 and the optical waveguide material 1 is arranged at the middle of these superconductive thin wires. In this case, the superconductor 31 uses $Nb_3Sn$, the stabilizing material 32 uses Cu, the supporting material 38 uses Cu, and the optical waveguide material 1 uses optical glass for an optical waveguide.

The superconductive wire of the present invention comprising the above components is manufactured according to the procedure below.

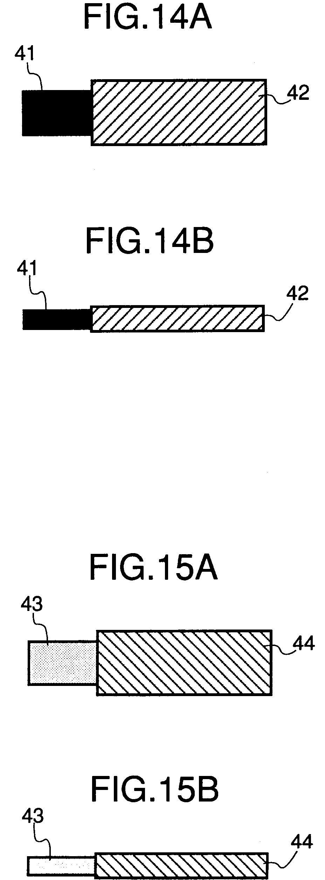

First, as shown in Fig. 14A, a superconductor 41 is inserted into a pipe made of a stabilizing material 42 before forming the conductor into a thin wire by passing the pipe through a small hole as shown in Fig. 14B.

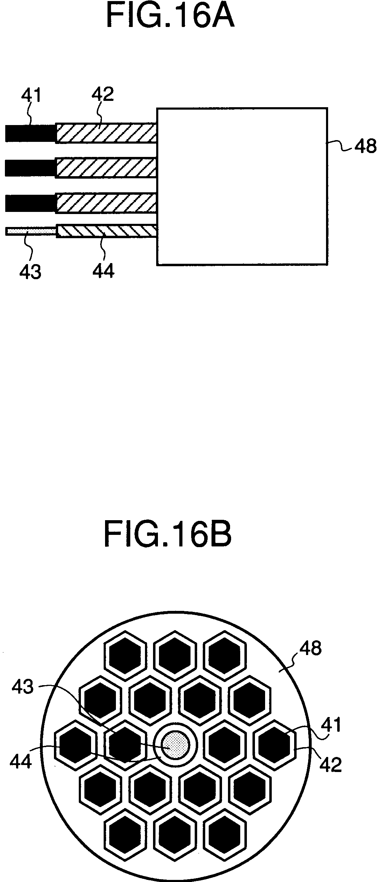

An optical glass material 43 and a stabilizing material 44 are arranged as shown in Fig. 15A before making them thin while heating them as shown in Fig. 15B. A plurality of superconductive wires thus formed and a thin line comprising an optical waveguide material are inserted into a supporting material 48 as shown in Fig. 16A so that the cross section is as shown in Fig. 16B and the both ends of the supporting material 48 are closed with a lid made of the same material as the supporting material 48 respectively to weld the material 48 with the lids as shown in Fig.

17A. In this case, the both welded portions are expressed as the symbol 45.

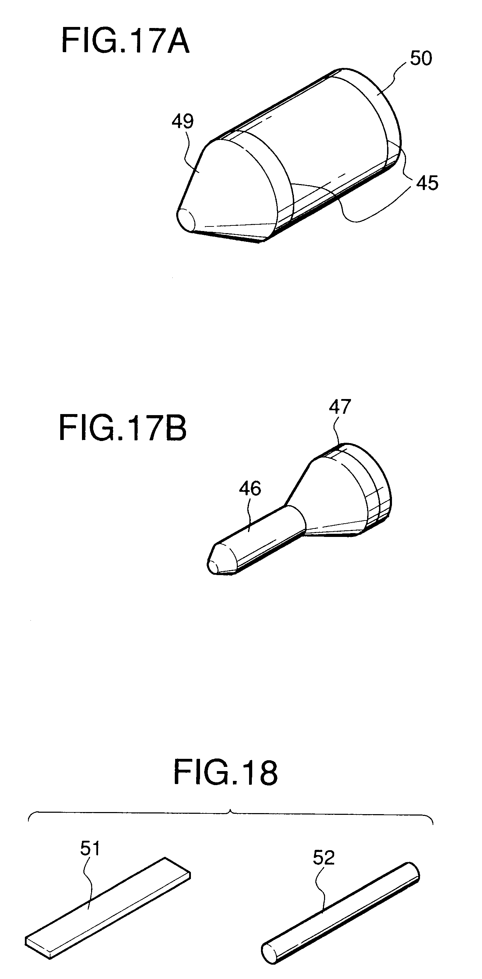

Then, the material 48 with the both ends closed is heated up to the softening temperature of optical glass and wire-drawn again as shown in Fig. 17B. It is possible to form the shape of the superconductive wire of the present invention into a round bar 52 or a rectangular bar 51 as shown in Fig. 18 according to the shape of a nozzle used for the above wire-drawing. Moreover, it is possible to optionally set the diameter of a superconductive thin wire used and that of an optical waveguide material used according to the purpose. In this case, however, the diameter of the superconductor 41 was set to 90 $\mu$m that of the optical waveguide material was set to 500 $\mu$m, and the entire diameter of the superconductive wire of the present invention to be formed was set to 1.05 mm. The critical current density of the superconductive wire was 900 A/mm$^2$ under the magnetic field condition of 15 T.

An argon laser beam (488 nm, 10 mW) was made to enter the optical waveguide material 43 of the superconductive wire (length of 300 m) of the present invention made through the above manner from one end of it.

As a result, the entered light reached the other end of the optical waveguide material 43 when flowing no current through the superconductive wire. In this case, no reflected light was detected at the light entering end.

However, reflected light was detected at the light entrance when flowing current approximately equal to the critical current of the superconductive wire through the superconductive wire. When flowing larger current, the reflected light intensity increased. The time until reflected light was detected after applying light to the wire was 400 psec as the result of measuring the time with a photomultiplier with a gate. Therefore, it is found that a portion where the optical waveguide material was deformed, that is, where a trouble such as quench occurred is at a position "0.3 (m/psec) x 400/2 (psec) = 60 (m)" apart from the light entrance when assuming the speed of light as 0.3 (m/psec).

Example 11:

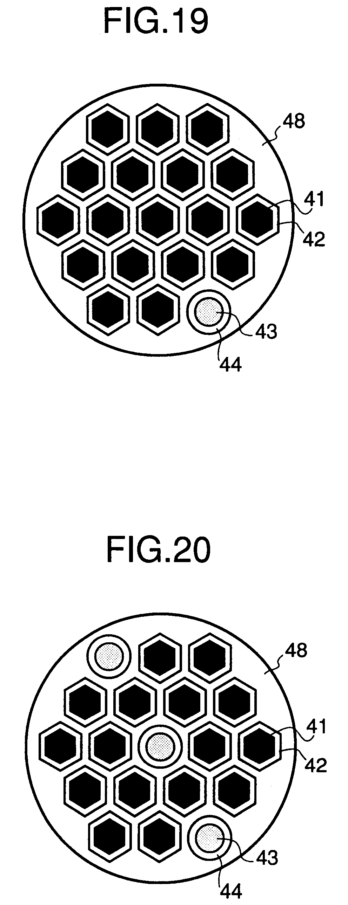

Fig. 19 is an illustration showing the principle of the cross-sectional structure of the superconductive wire of another mode of the present invention. For this mode, unlike the case of Example 10, an optical waveguide material 43 is deviated from the center of a supporting material 48. The material used is the same as that of Example 10.

Even for the above structure, a superconductive wire with the critical current density of approx. 10$^3$ A/mm$^2$ was obtained under the magnetic field condition of 10 T. Moreover, a trouble on the superconductive wire could be detected by applying light to the optical waveguide material similarly to Example 10.

Example 12:

Fig. 20 is an illustration showing the principle of the cross-sectional structure of the superconductive wire of still another mode of the present invention. For this mode, three optical waveguide materials 43 are arranged in a supporting material 48. The superconductor uses a BiSrCaCuO-based oxide superconductor and its critical temperature is 120 K. The stabilizing material uses Ag. The optical waveguide material uses acrylic resin, to which light can be applied entirely or locally. Moreover, the both ends of the optical waveguide material can be separated or put together.

When the both ends of the optical waveguide were put together, an electrification test was performed by using a helium-neon laser beam (633 nm, output: 20 mW) for a superconductive wire with the length of 100 m.

For this example, the diameter of the superconductor 41 used is 50 $\mu$m and the area ratio of the superconductor to the stabilizing material 42 covering the superconductor is set to 1 : 2. One thousand superconductive thin wires thus formed are inserted into the supporting material 48. The optical waveguide made of acrylic resin is inserted into a Cu pipe whose diameter is 200 $\mu$m.

The superconductive wire of the present invention thus formed was kept at the liquid-nitrogen temperature to perform trouble detection with light while changing the current applied to the superconductor. As a result, a trouble of the superconductive wire could be detected similarly to the cases of Examples 10 and 11.

Example 13:

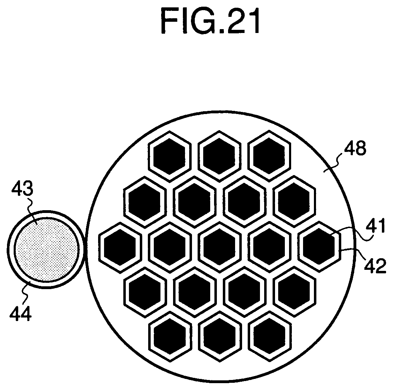

Fig. 21 is an illustration showing the principle of the cross-sectional structure of the superconductive wire of still another mode of the present invention. For this mode, an optical waveguide material is set outside a superconductive wire.

A superconductor section to which current was applied and an optical waveguide section were separately manufactured by using the same materials as those used for Example 12 before the optical waveguide section was attached to the superconductor section by solder or adhesive at the final wire-drawing to form the superconductive wire of the present invention.

Trouble detection of the superconductive wire was performed by applying an argon ion laser beam (514.5 nm, 20 mW) to the optical waveguide section of the superconductive wire of the present invention from one end of it and detecting light with a CCD camera with a gate at the other end of the superconductive wire. As a result, a trouble of the superconductive wire could be detected similarly to the case of Example 10.

As described above, the superconductive wire of the present invention makes it possible to detect a trouble such as quench or disconnection of the superconductive wire at any temperature zone from the initial stage of the trouble by setting an optical waveguide section very closely to a portion where current flows, applying light to the optical waveguide section, and detecting the light at one end or both ends of an optical waveguide material.

## Claims

1. A method for detecting superconductor quench which comprises a step (a) of entering light into an optical waveguide material arranged closely to a superconductor, and a step (b) of detecting a change of the incident light in the optical waveguide material.

2. The method for detecting superconductor quench according to Claim 1 wherein the optical waveguide material is arranged around the superconductor.

3. The method for detecting superconductor quench according to Claim 1 wherein the optical waveguide material is constituted integrally with the superconductor via a substrate.

4. The method for detecting superconductor quench according to Claim 1 wherein the detection of the incident light change in the light waveguide material is carried out by detecting a course change of the incident light in the optical waveguide material.

5. The method for detecting superconductor quench according to Claim 4 wherein the detection of the course change of the incident light is carried out by detecting the reflected light of the incident light.

6. The method for detecting superconductor quench according to Claim 4 wherein the detection of the course change of the incident light is carried out by detecting an intensity change of the outgoing light from the optical waveguide material.

7. The method for detecting superconductor quench according to Claim 4 wherein the detection of the course change of the incident light is carried out by detecting a polarizing state of the outgoing light from the optical waveguide material.

8. The method for detecting superconductor quench according to Claim 7 wherein the detection of the polarizing state is carried out by detecting a gradient of the outgoing light or a phase change of a polarized component.

9. The method for detecting superconductor quench according to Claim 1 which further has a step (c) of changing an amount of electrification current to the superconductor in compliance with the detected data.

10. The method for detecting superconductor quench according to Claim 1 which further has a step (d) of changing the feed of a refrigerant to the superconductor in compliance with the detected data.

11. The method for detecting superconductor quench according to Claim 1 which further has a step (e) of detecting a course change site of the incident light in the optical waveguide material to detect a quench site of the superconductor.

12. The method for detecting superconductor quench according to Claim 11 wherein the detection of the course change site of the incident light is carried out by detecting a time of from the incident point of light to the optical waveguide material to the outgoing point of the reflected light from the optical waveguide material.

13. The method for detecting superconductor quench according to Claim 11 which further has a step (c) of changing an amount of electrification current to the superconductor in compliance with the detected data.

14. The method for detecting superconductor quench according to Claim 11 which further has a step (d) of changing the feed of a refrigerant to the superconductor in compliance with the detected data.

15. The method for detecting superconductor quench according to Claim 1 which further has a step (f) of detecting an intensity of the outgoing light from the optical waveguide material to detect a degree of the quench of the superconductor.

16. The method for detecting superconductor quench according to Claim 15 wherein the detection of the outgoing light intensity is carried out by detecting an intensity change of transmitted light or reflected light.

17. The method for detecting superconductor quench according to Claim 15 wherein the detection of the outgoing light intensity is carried out by detecting a difference between the intensity of transmitted light or reflected light and the intensity of the incident light.

18. The method for detecting superconductor quench according to Claim 15 which further has a step (c) of changing an amount of electrification current to the superconductor in compliance with the detected data.

19. The method for detecting superconductor quench according to Claim 15 which further has a step (d) of changing the feed of a refrigerant to the superconductor in compliance with the detected data.

20. The method for detecting superconductor quench according to Claim 1 which further has a step (g) of detecting an intensity ratio between a Stokes Raman line and an anti-Stockes Raman line contained in the outgoing light from the optical waveguide material to detect a temperature change amount at the quench site of the superconductor.

21. The method for detecting superconductor quench according to Claim 20 which further has a step (c) of changing an amount of electrification current to the superconductor in compliance with the detected data.

22. The method for detecting superconductor quench according to Claim 20 which further has a step (d) of changing the feed of a refrigerant to the superconductor in compliance with the detected data.

23. An apparatus for detecting superconductor quench which comprises an optical waveguide material arranged closely to a superconductor, a means for entering light into the optical waveguide material, and a means for detecting a change of the incident light in the optical waveguide material.

24. The apparatus for detecting superconductor quench according to Claim 23 wherein the means for detecting the incident light change in the optical waveguide material is a means for detecting a course change of the incident light in the optical waveguide material.

25. The apparatus for detecting superconductor quench according to Claim 24 wherein the means for detecting the course change of the incident light is a means for detecting the reflected light of the incident light.

26. The apparatus for detecting superconductor quench according to Claim 24 wherein the means for detecting the course change of the incident light is a means for detecting an intensity change of the outgoing light from the optical waveguide material.

27. The apparatus for detecting superconductor quench according to Claim 24 wherein the means for detecting the course change of the incident light is a means for detecting a polarizing state of the outgoing light from the optical waveguide material.

28. The apparatus for detecting superconductor quench according to Claim 27 wherein the means for detecting the polarizing state is a means for detecting a gradient of the outgoing light or a phase change of a polarized component.

29. The apparatus for detecting superconductor quench according to Claim 23 which has a means for changing an amount of electrification current to the superconductor in compliance with the detected data.

30. The apparatus for detecting superconductor quench according to Claim 23 which has a means for changing the feed of a refrigerant to the superconductor in compliance with the detected data.

31. The apparatus for detecting superconductor quench according to Claim 23 which has a means for detecting a course change site of the incident light in the optical waveguide material to detect a quench site of the superconductor.

32. The apparatus for detecting superconductor quench according to Claim 31 wherein the means for detecting the quench site is a means for detecting a time of from the incident point of light to the optical waveguide material to the outgoing point of the reflected light from the optical waveguide material.

33. The apparatus for detecting superconductor quench according to Claim 31 which has a means for changing an amount of electrification current to the superconductor in compliance with the detected data.

34. The apparatus for detecting superconductor quench according to Claim 31 which has a means for changing the feed of a refrigerant to the superconductor in compliance with the detected data.

35. The apparatus for detecting superconductor quench according to Claim 23 which has a means for detecting an intensity of the outgoing light from the optical waveguide material to detect a degree of the quench of the superconductor.

36. The apparatus for detecting superconductor quench according to Claim 35 wherein the means for detecting the degree of the quench is a means for detecting an intensity change of transmitted light or reflected light.

37. The apparatus for detecting superconductor quench according to Claim 35 wherein the means for detecting the degree of the quench is a means for detecting a difference between the intensity of transmitted light or reflected light and the intensity of the incident light.

38. The apparatus for detecting superconductor quench according to Claim 35 which has a means for changing an amount of electrification current to the superconductor in compliance with the detected data.

39. The apparatus for detecting superconductor quench according to Claim 35 which has a means for changing the feed of a refrigerant to the superconductor in compliance with the detected data.

40. The apparatus for detecting superconductor quench according to Claim 23 which has a means detecting an intensity ratio between a Stokes Raman line and an anti-Stockes Raman line contained in the outgoing light from the optical waveguide material to detect a temperature change amount at the deformation site of the optical waveguide material.

41. The apparatus for detecting superconductor quench according to Claim 40 which has a means for changing an amount of electrification current to the superconductor in compliance with the detected data.

42. The apparatus for detecting superconductor quench according to Claim 40 which has a means for changing the feed of a refrigerant to the superconductor in compliance with the detected data.

43. A superconductive wire in which a superconductor is constituted integrally with an optical waveguide material via a substrate.

44. The superconductive wire according to Claim 43 wherein the optical waveguide material is constituted of an optical transparent material.

45. The superconductive wire according to Claim 43 wherein the substrate is constituted of a thermally conductive material.

46. The superconductive wire according to Claim 43 wherein the superconductor is constituted of a superconductive material having a critical temperature of 25 K or higher.

47. The superconductive wire according to Claim 43 wherein a low resistor is arranged around the superconductor.

48. The superconductive wire according to Claim 47 wherein the low resistor is constituted of at least one material selected from the group consisting of metals, alloys, intermetallic compounds and superconductive materials having a critical temperature of 25 K lower.

49. A method of detecting disturbance in a superconductor by detecting an optical disturbance in an associated optical pathway.

50. A superconductor element or an element capable of superconductivity in association with an optical pathway arranged to undergo an optical disturbance if the element undergoes a disturbance of its superconducting state.

51. Apparatus for detecting disturbance in a superconductor comprising an optical pathway to be associated with the superconductor in use and means to analyse optical disturbance in the optical pathway.

# FIG.1

# FIG.2

# FIG.3

# FIG.4

# FIG.5

# FIG.6

$t_1$

DETECTOR 8

$t_3$

$t_2$

DETECTOR 9

0

TIME

# FIG.7

$t_1$

$t_4$

$t_5$

DETECTOR 8

$t_2$

$t_6$

$t_7$

DETECTOR 9

0

TIME

# FIG.8

# FIG.9

EP 0 538 072 A2

# FIG.10

INCIDENT
LIGHT

EMITTED
LIGHT

17    16

14

15    18

# FIG.11

38

1

34    31

32

# FIG.12

# FIG.13A

INTENSITY

TIME

# FIG.13B

DIFFERENTIAL
ABSOLUTE
VALUE

TROUBLE

THRESHOLD
VALUE

TIME

# FIG.14A

41

42

# FIG.14B

41

42

# FIG.15A

43

44

# FIG.15B

43

44

# FIG.16A

# FIG.16B

## FIG.17A

49

50

45

## FIG.17B

47

46

## FIG.18

51

52

# FIG.19

# FIG.20

# FIG.21